# EUROPEAN PATENT APPLICATION

(11) **EP 4 560 685 A1**
(43) Date of publication of application: **28.05.2025**
(21) Application number: 24214647.0
(22) Date of filing: 21.11.2024
(51) Int. Cl.: H01L 21/50, H01L 23/053, H01L 23/055

(54) **PANEL LEVEL FABRICATION OF STACKED ELECTRONIC DEVICE PACKAGES WITH ENCLOSED CAVITIES**

(30) Priority: 22.11.2023 US 202318518368
(71) Applicant: NXP USA, Inc., Austin, TX 78735 (US)
(72) Inventor: KISHORE, Sharan, 5656AG Eindhoven (NL); LASHMINARAYAN, Viswanathan, 5656AG Eindhoven (NL); FERNANDO, Santos A., 5656AG Eindhoven (NL); VAN STRATEN, Freek Egbert, 5656AG Eindhoven (NL)
(74) Representative: Hardingham, Christopher Mark

(57) **Abstract**

Electronic device packages that include one or more circuit substrates, one or more cavities defined by a cover separated from a circuit substrate by an interposer substrate with an aperture disposed above the circuit substrate can be formed by panel-level fabrication processes in which multiple assemblies are formed by singulating a larger panel assembly formed by multiples panels bonded to each other. A panel that includes multiple levels is partially diced to form channels which are filled with molding material. The subsequent structure is diced again to singulate individual stacked packages that include a portion of the molding material surrounding one or more interposers. The molding material can seal gaps between an interposer and a circuit substrate to which it is bonded, as well as providing electrical isolation between electrical interconnects that would otherwise be exposed at edges of each package.

## Description

### TECHNICAL FIELD

Embodiments of the subject matter described herein relate to methods of forming packages for electronic devices that include multiple circuit boards or other substrates.

### BACKGROUND

Electronic devices such as integrated circuits are often packaged in polymer or ceramic housings which can be designed to protect the devices from damage, help dissipate heat, and to provide macroscopic contacts that allow the devices to be coupled to other devices on printed circuit boards and other substrates. In some applications, it is desirable to provide a hollow or gas-filled cavity within a package to accommodate high-frequency components.

### SUMMARY

In an example embodiment, a method includes receiving a first substrate panel having an upper surface and lower surface and receiving a second substrate panel having an upper surface and lower surface. The first substrate panel includes a first circuit substrate and the second substrate panel includes a first interposer substrate having an aperture that passes through the first interposer substrate.

The method further includes bonding the lower surface of the second substrate panel to the upper surface of the first substrate panel such that the aperture of the first interposer substrate is positioned above the first circuit substrate on the upper surface of the first substrate panel; and bonding a first cover to the upper surface of second substrate panel such that a first cavity is formed between the first circuit substrate and the first cover.

**The** method further includes dicing channels in the second substrate panel that pass through the first interposer substrate and expose portions of the upper surface of the first substrate panel that surround the first circuit substrate. The method further includes dispensing a molding material in the channels in the second substrate panel such that aperture in the first interposer substrate is surrounded by the molding material. The method further includes producing a singulated device assembly by dicing through a portion of the molding material in the channels in the second substrate panel and through portions of the first substrate panel underneath the channels.

The singulated device assembly includes the first circuit substrate; the first interposer substrate bonded to an upper surface of the first circuit substrate at a lower surface of the first interposer substrate; and the first cover bonded to an upper surface of the first interposer substrate.

In another example embodiment, a method includes providing a panel assembly. The panel assembly includes a first substrate panel that includes a set of first circuit substrates that include electronic components; and a second substrate panel bonded above the first substrate panel that includes a set of first interposer substrates having apertures disposed over corresponding first circuit substrates of the first substrate panel.

The method further includes partially dicing the panel assembly to form channels that pass through the second substrate panel. The method further includes singulating the panel assembly into singulated circuit assemblies by dicing through a portion of the molding material in the channels that pass through the second substrate panel and dicing through the first substrate panel beneath the channels.

Each singulated circuit assembly includes a first circuit substrate; a first interposer substrate bonded above the first circuit substrate and including a first aperture disposed above a first portion of the first circuit substrate; a first cover bonded above the first aperture such that a first cavity is formed above the portion of the first circuit substrate; and molding material that at least partially surrounds the first interposer substrate.

In yet another example embodiment, a method includes providing a panel assembly including a first substrate panel and a second substrate panel. The first substrate panel includes a set of first circuit substrates that include electronic components and the second substrate panel is bonded above the first substrate panel. The second substrate panel includes a set of first interposer substrates having apertures disposed over corresponding first circuit substrates of the first substrate panel.

**The** method also includes partially dicing the panel assembly to form channels that pass through the second substrate panel. The method also includes singulating the panel assembly into singulated circuit assemblies by dicing through a portion of molding material in the channels that pass through the second substrate panel and dicing through the first substrate panel beneath the channels.

Each singulated circuit assembly includes a first circuit substrate that includes a thermally-conductive structure that passes through the first circuit substrate; a first interposer substrate bonded above the first circuit substrate and including a first aperture disposed above a first portion of the first circuit substrate; a first cover bonded above the first aperture such that a first cavity is formed above the portion of the first circuit substrate; and an electronic device disposed on an upper surface of the first circuit substrate and thermally coupled to a lower surface of the first circuit substrate via the thermally-conductive structure.

In one more embodiments, each singulated assembly further includes a portion of the molding material in the channels that pass through the second substrate panel that remains after dicing through the channels. In one or more embodiments, each singulated assembly further includes one or more electronic components disposed on or within the first circuit substrate that are electrically coupled to an electrical contact outside the first cavity via an electrical interconnect within the first interposer substrate. In one or more embodiments, the molding material electrically isolates electrically conductive structures of the first interposer substrate.

### BRIEF DESCRIPTION OF THE DRAWINGS

**The** present disclosure is illustrated by way of examples, embodiments and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
**FIG.** 1A is a partially exploded cross-sectional view of a stacked assembly that includes a lidded cavity according to one or more embodiments.
FIG. 1B is an assembled cross-sectional view of the assembly of FIG. 1A.
FIG. 2A is a partially exploded cross-sectional view of a stacked assembly related to the assembly of FIG. 1A and FIG. 1B in which the lidded cavity is replaced with another circuit substrate according to one or more embodiments.
FIG. 2B is an assembled cross-sectional view of the assembly of FIG. 2A.
FIG. 3 is a process flow diagram illustrating cross-sectional views of an assembly according to one or more embodiments during an example fabrication process.
FIG. 4 is a partially exploded cross-section of another example assembly that illustrates embodiments in which carriers are joined to each other via interposers via a system of mating pins and sockets.
FIG. 5 is a cross-sectional view of a mult-tiered assembly that includes two cavities according to one or more embodiments.
FIG. 6A is a cross-sectional view illustrating partial dicing of a multi-tier panel-level assembly that includes multiple stacked carriers with cavities between them according to one or more embodiments.
FIG. 6B a cross-sectional view illustrating molding of the panel-level assembly of FIG. 6A.
FIG. 6C is a cross-sectional view illustrating singulation of the panel-level assembly of FIG. 6A and FIG. 6B.

### DETAILED DESCRIPTION

**The** following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

**The** terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration.

Unless explicitly stated otherwise, the use of terms "approximately," "substantially" and similar terms in connection with dimensions, relative positioning, or orientation of various features indicates that the dimensions, positioning, or orientation of those features are subject to tolerances and/or expected process variations of equipment and processes chosen to form the described features. Unless explicitly stated otherwise, the use of terms "approximately," "substantially" and similar terms in connection measurable values or characteristics is subject to the expected measurement accuracy of equipment and methods used to measure those values or characteristics and/or within tolerance limits specified by technical standards applicable to the technologies described.

It will be appreciated that the steps of various processes described herein are non-limiting examples of suitable processes according to embodiments and are for the purposes of illustration. Embodiments herein may use any suitable processes including those that omit steps described herein, perform those steps and similar steps in different orders, and the like. It will also be appreciated that well-known features and techniques may be omitted for clarity.

Conventional techniques for packaging and encapsulating electronic devices include methods in which components are stacked on top of each or otherwise occupy multiple levels. However, such methods often involve bonding of one or more discrete monolithic devices or packaged devices on a substrate or directly on another monolithic device or packaged device, which can have disadvantages. As one example, the performance of radio-frequency (RF), microwave (MW) and millimeter-wave (mmWave) devices may be impaired when such devices and/or related components coupled to those devices are surrounded by dielectric materials such as polymer molding materials due to signal losses caused by attenuation of high frequency signals due to absorption within the dielectric(s).

Accordingly, benefits of embodiments herein can include enabling cost-effective manufacturing of multilevel electronic device assemblies with cavities above sensitive components that can be gas-filled, evacuated, or filled with other materials to achieve desired performance characteristics. Stacked assemblies according to one or more embodiments can have any suitable number of levels and devices on different levels can be isolated or interconnected as desired by way of interposer substrates which can include interconnections between layers and can also form part of metallic shield structures suitable for isolating selected layers or devices from electromagnetic interference.

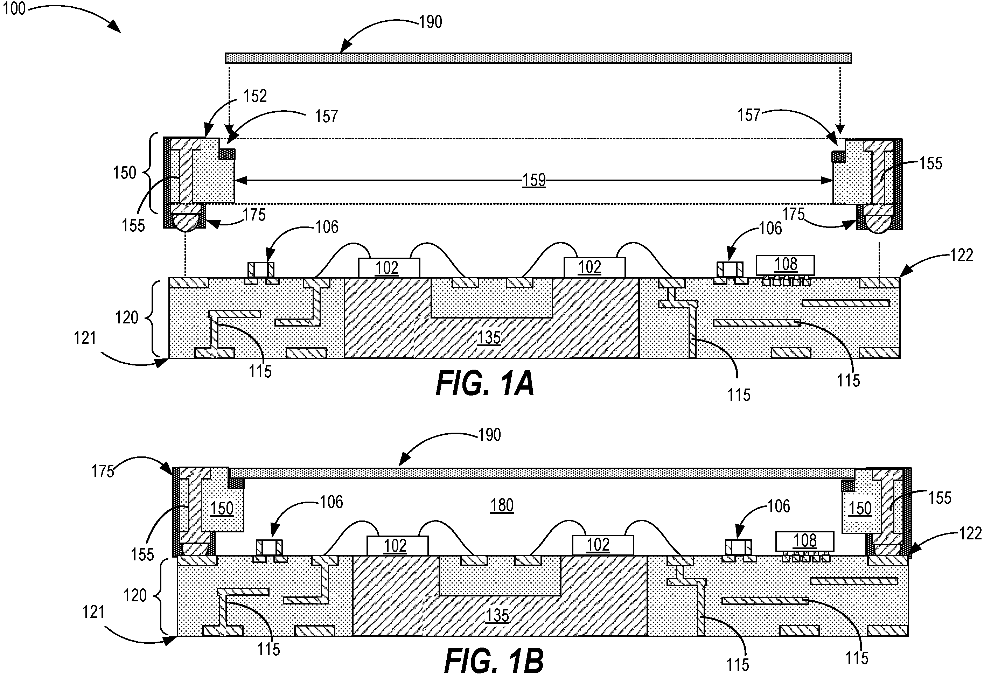

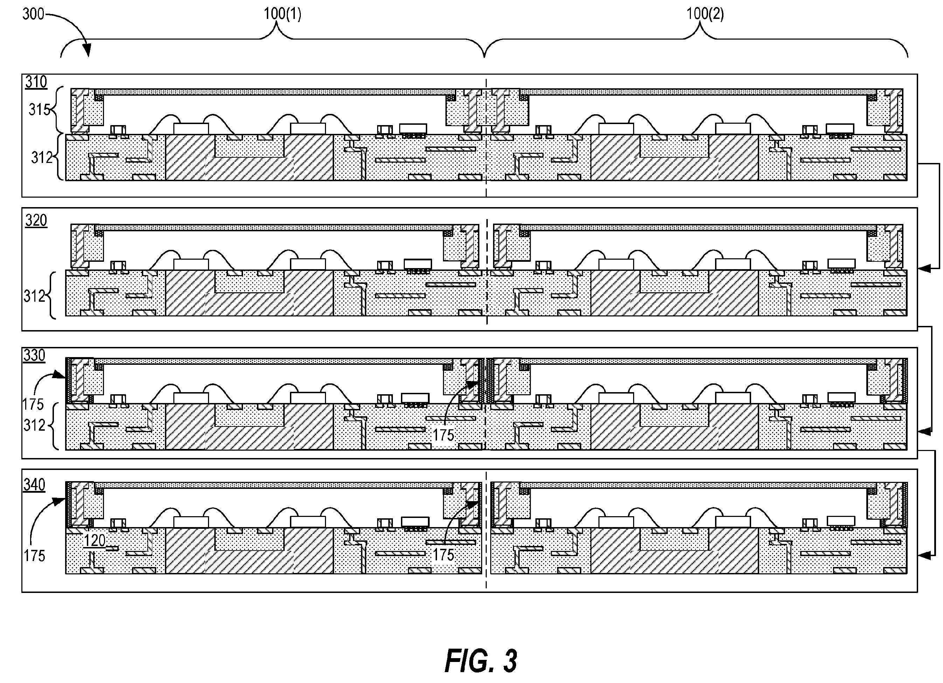

Along these lines, FIG. 1A is a partially exploded cross-sectional view of an example assembly 100 which can be manufactured in a panel-level process according to one or more embodiments (a panel-level fabrication process is described later in connection with FIG. 3). The assembly 100 is formed from a carrier 120 which has a lower surface 121 and an upper surface 122. An interposer substrate (an interposer 150) is bonded to the upper surface 122 of the carrier 120 by any suitable method such as solder bonding using solder bumps as shown in the examples of FIG. 1A and FIG. 1B.

A carrier such as the carrier 120 can include active and passive electronic devices on its surfaces (e.g., the lower surface 121 and the upper surface 122). Such carriers can include electrically conductive interconnects such as the interconnects 115 disposed within the carrier and on its upper and lower surfaces. As shown, interconnects such as the interconnects 115 can include metalized pads such as those shown on the lower surface 121 and/or the upper surface 122 of the carrier 120 and electronic devices (which can include active devices, passive devices, or both in any suitable arrangements) can be coupled to such pads using any suitable methods to the interconnects. As examples, electronic devices 102 (e.g., semiconductor device die) are shown wire-bonded to interconnects 115 at the upper surface 122 of the carrier 120. As further examples, passive components 106 (e.g., discrete resistors, capacitors, inductors, and the like) are shown with metallic contacts bonded to interconnects on the upper surface 122 of the carrier 120. As a further example an electronic devices 108 is depicted with metal pillars bonded to interconnects 115 on the upper surface 122 of the carrier 120.

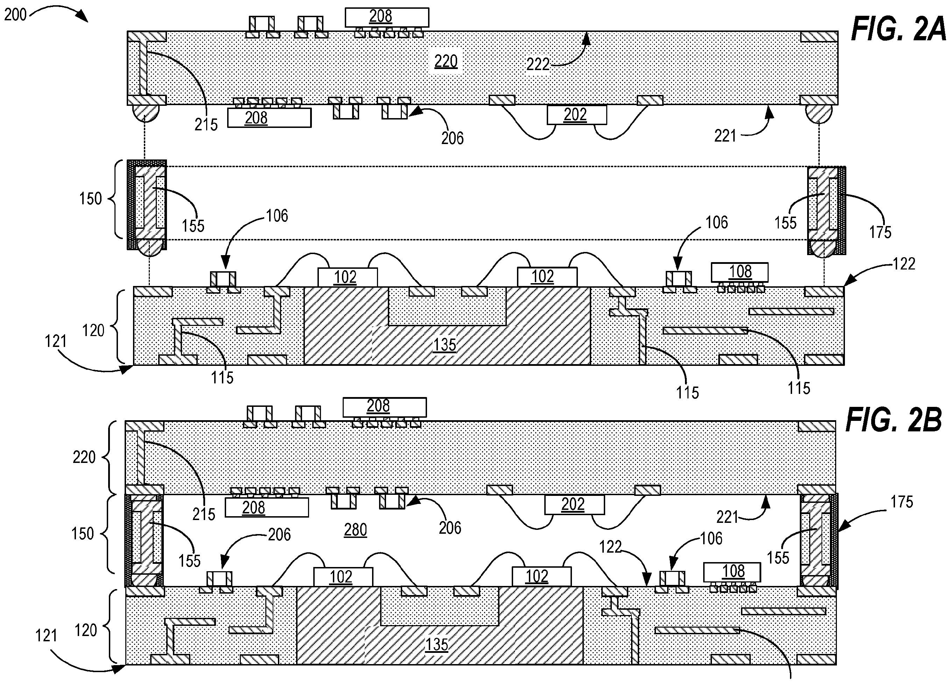

**A** carrier such as the carrier 120 can be mechanically coupled to other structures (e.g., the cover 190) in a stacked arrangement by way of an interposer substrate, or "interposer" (e.g., the interposer 150 shown). Interposer substrates can include electrical interconnects 155 and can be bonded or otherwise mechanically coupled between adjacent structures (e.g., between the carrier 120 and the cover 190 or between two carriers as described below in connection with FIG. 2). An interposer 150 can be bonded to the carrier 120 via solder bump bonding to contact pads (i.e., interconnects 115 at surfaces of the carrier 120), solder reflow, epoxy bonding, and/or any other suitable methods. An interposer substrate such as the interposer 150 may be formed from any suitable materials, including, but not limited to, materials similar or identical to those used to form a carrier such as the carrier 120.

In one or more embodiments, a carrier such as the carrier 120 is also electrically coupled to one or more other such carriers in an assembly such as the assembly 200 of FIG. 2 via interconnects (e.g., an interconnect 155) within an interposer such as an interposer 150. In other words, an interconnect (e.g., an interconnect 115), electronic component (e.g., a component or electronic device 102, 106, 108), or other feature on or within the first carrier is electrically coupled to one or more interconnects, electronic components, or other features on or within the other carrier(s). Alternatively, in one or more embodiments, exposed contacts on a top surface of an interposer (e.g., the upper surface 152 of the interposer 150) are electrically coupled to devices or other structures on or within a carrier coupled to that interposer, as shown in FIG. 1A and FIG. 1B.

It will be appreciated that when a carrier (e.g., the carrier 120) is coupled to a lidded interposer (e.g., the interposer 150 having the aperture 159 that passes through it to which the cover 190 has been bonded) or when two or more carriers (e.g., carriers 120) are mechanically coupled to each other via interposers (e.g., interposers 150), a cavity can be formed between two adjacent carriers (e.g., the cavity 180 of FIG. 1B formed when the aperture 159 is disposed over the carrier 120 and the aperture 159 is covered by the lid 190). In one or more embodiments, such a cavity is hollow or gas-filled (e.g., with air or an inert gas). Such hollow or gas-filled cavities can be desirable for certain applications. For example, if radiofrequency (RF), microwave (MW), millimeter-wave (mmWave), or other high frequency electrical signals are propagated in the cavity or along a surface surrounded by the cavity (e.g., along a waveguide formed on a surface of a carrier 120), signal attenuation can be minimized compared with other packaging approaches in which spaces between adjacent stacked circuit layers are filled with polymer materials and the like. In addition, when compared to other approaches in which a single circuit substrate is sealed in a lidded package to create a hollow or gas-filled cavity, embodiments herein allow such cavities to be incorporated into high density packages with multiple circuit layers (e.g., multiple carriers such as a carrier 120). Furthermore, an assembly such as the assembly 100 may include multiple hollow or gas-filled cavities by using an interposer with multiple apertures such as the aperture 159 and/or by bonding multiple interposers with apertures on the surface of a single carrier such as the carrier 120.

In one or more embodiments, an interposer such as the interposer 150 is surrounded by one or more volumes of molding material (e.g., the molding material 175, shown in FIG. 1 and FIG. 1B). Such molding material can serve to seal gaps between the interposer and a carrier such as the carrier 120 to which the interposer is mounted, allowing the cavity to remain hollow, to be evacuated, or to be filled with another material including, but not limited to air or another gas. The molding material can also provide electrical isolation of electrical interconnects (e.g., the interconnects 155 of the interposer 150 or interconnects 115 of the carrier 120 that would otherwise be exposed at surfaces or edges of the carrier 120) and other conductive structures. The use of molding materials such as the molding material 175 is described further below in connection with FIG. 3.

As shown in FIG. 1A and FIG. 1B, carriers can include additional structures such as heat sinks (e.g., thermally conductive heat sink 135 forming part of the carrier 120, which may be referred to as a "coin"). Assemblies herein may also include additional structures which can be used as external contacts such as metalized pads, solder bumps, combinations thereof and the like on any suitable surface (e.g., the lower surface 121 of the carrier 120 or the upper surface 152 of the interposer 150). It will be appreciated that such features can allow for an assembly to be mounted to a circuit board or other substrate via one surface (e.g., the upper surface 152 and/or the cover 190) and also to be coupled to an additional heat sink assembly at another surface (e.g., the lower surface 121 of the carrier 120) via structures such as the heat sink 135 in a so-called top-side cooling arrangement.

FIG. 2A shows a partially exploded cross-sectional view of another example assembly in which a second carrier substrate is used rather than a cover such as the cover 190 of FIG. 1A and FIG. 1B. The assembly 200 is formed by two circuit substrates (carriers 120 and 220; e.g., polymer-based printed circuit boards, ceramic-based circuit boards, and the like, as non-limiting examples, represented by the carrier 120 and the second carrier 220, which replaces the cover 190 of the assembly 100. The carrier 220 has a lower surface 221 and an upper surface 222. As shown, the carrier 220 can include electronic devices and other components on one or both of the surfaces 221, 222 as illustrated by the components 202, 206, and 208 (e.g., components 102, 106, and 108, respectively). As shown, a carrier such as the carrier 220 can include interconnects such as the interconnects 215 (e.g., interconnects 115). The interconnects 215 can be coupled to interconnects 155 of the interposer 150. Thus, it will be appreciated that, in one or more embodiments, components on or within a first carrier such as the carrier 120 can be coupled to components on or within another carrier such as the carrier 220 via interconnects in an interposer such as the interposer 150.

It will be appreciated that the assembly 200 is a non-limiting example and that embodiments herein can include any suitable number of carriers and interposers and fabricated from any suitable materials and including any number and type of suitable devices. In other words, assemblies fabricated according to embodiments herein can include two are more "tiers", each of which may be populated on one or both surfaces with any suitable components.

Each carrier (e.g., a carrier 120, 220) can include active and passive electronic devices on its lower surface, upper surface, or both surfaces. Each carrier can include electrically conductive interconnects (e.g., interconnects 115, 215) disposed within the carrier and on its top and lower surfaces. As shown, interconnects 115 can include metalized pads on the lower surface 121 and/or the upper surface 122 of the carrier 120 and electronic devices (which can include active devices, passive devices, or both in any suitable arrangements) can be coupled to such pads using any suitable methods to interconnects 115. Components or other structures on or within the carrier substrate 120 can be electrically coupled to components on or within the carrier 220 by way of the interconnects 155 of the interposer 150 and interconnects 215 of the carrier 220.

**The** carriers 120, 220 are mechanically coupled to each other in a stacked arrangement by way of the interposer 150. In the example of FIG. 2A and FIG. 2B, the interposer 150 includes electrical interconnects 155 and are bonded or otherwise mechanically coupled between the carriers 120, 220. Interposers such as the interposer 150 can be bonded to carriers such as the carriers 120, 220 via solder bump bonding to contact pads (e.g., interconnects 115 at surfaces of the carriers 120, 220), solder reflow, epoxy bonding, and/or any other suitable methods. In one or more embodiments, a first carrier such the carrier 120 is also electrically coupled to one or more other such carriers in an assembly such as the assembly 200 via interconnects (e.g., an interconnect 155) within an interposer such as an interposer 150. In other words, an interconnect (e.g., an interconnect 115), electronic component (e.g., a component or electronic device 102, 106, or 108), or other feature on or within the first carrier is electrically coupled to one or more interconnects, electronic components, or other features on or within a second carrier such as the carrier 220.

It will be appreciated that when two or more carriers (e.g., carriers 120) are mechanically coupled to each other via interposers (e.g., interposers 150), a cavity can be formed between the two carriers (e.g., the cavity 280 between the carrier 120 and the carrier 220). When compared to other approaches in which a single circuit substrate is sealed in a lidded package to create a hollow or gas-filled cavity, embodiments herein allow such cavities to be incorporated into high density packages with multiple circuit layers (e.g., multiple carriers 120 or 220) and to be manufactured in high-volume processes as will be described further below. Furthermore, an assembly such as the assembly 200 may include multiple hollow or gas-filled cavities separated from each other by portions of an interposer substrate.

It will be understood that the assemblies 100, 200 and other assemblies depicted herein are for purposes of illustration and may show elements which are omitted in certain embodiments or show elements which are absent and that elements may be added or omitted purely to provide illustrative examples. Along these lines, in embodiments described herein, interconnects (e.g., interconnects 115 and interconnects 155) can be arranged in any suitable manner. For instance, as shown in FIGs. 1A, 1B, 2A, and 2B, interconnects such as interconnects 115 or 215 can be routed on surfaces of carriers and within carriers in order connect electronic devices to other devices on the same surface or to devices or external contact pads on an opposite surface of the same carrier. Interconnects within interposers (e.g., interconnects 155 within interposers 150) can be used to form electrical connections between different carriers. For example, on the left side of FIG. 1, various interconnects 115 and interconnects 155 are coupled to each other such that there is a continuous electrically conductive path from the discrete carrier 120A to one of the solder bumps 195 on the upper surface 122C of the carrier 120C. Alternatively, some connections between a carrier substrate and an interposer can serve as mechanical connections only.

FIG. 3 is a process flow diagram showing cross-sectional views of the assembly 100 during steps of an example process suitable for use to fabricate the assembly 100 or related assemblies such as the assembly 200. The process 300 includes steps 310, 320, 330, and 340. It will be understood that process 300 is an example presented for purposes of illustration and that processes according to embodiments herein may omit steps described as part of the process 300, add additional steps which are not explicitly described as part of the process 300, and/or may perform steps of the process 300 or similar steps in a different order than described in connection with the process 300.

**The** process 300 is an example of a so-called panel level process in which multiple discrete (or "singulated") substrates or assemblies are fabricated in parallel from larger substrates ("panels"). For ease of understanding the process 300 is described with reference to formation of two discrete assemblies 100(1) and 100(2) (e.g., assemblies 100). However, it will be understood that in processes according to embodiments herein, many more than two assemblies may be produced and also that individual assemblies need not be identical to each other and can differ in their layouts and/or components.

At step 310, an assembly is provided which is formed for by a first substrate panel 312 which includes two or more carriers (e.g., two identical carriers 120, as shown in FIG. 1A and FIG. 1B) bonded to a second substrate panel 315 which includes two or more lidded interposers (e.g., two identical interposers 150 with covers 190). An approximate midpoint between each of the panels 312, 315 is indicated by a vertical dashed line. In one or more embodiments, panels 312 and 315 are formed as received separately and bonded together using any suitable process including thermocompression bonding, solder reflow, conductive adhesive bonding, or the like.

At step 320, the panel 315 is diced to singulate the individual interposers 150 from each other as shown, without dicing the underlying panel 312. Alternatively, in one or more embodiments, a panel such as the panel 312 may be partially diced, without separating the panel 312 into individual carriers.

At step 330, the interposers 150 are molded by dispensing or otherwise forming volumes of a molding material (e.g., the molding material 175) surrounding the singulated interposers 150. In one or more embodiments, the molding material fills voids between the interposers 150 and the (to be singulated) carriers 120 of the panel 312. Any suitably flowable material or combination of materials may be used as molding materials such as the molding material 175 according to embodiments herein. For example, polymer materials, including adhesives, liquid crystal polymers and other materials may all be used.

At step 340, the assemblies 100 represented by the assembly 100(1) and the assembly 100(2) are fully singulated by dicing through the volume of molding material between each interposer 150 and through the panel 312. Any suitable method or combination of methods can be used to dice or singulated the assemblies 100 including the use of wafer sawing, laser cutting or scoring, water jetting, and the like as nonlimiting examples. As one non-limiting example one or more carriers or interposers may be formed from ceramic materials such as alumina, aluminum nitride, barium titanate and the long and can include conductive traces formed by direct bonding of copper or other methods. Such substrates can benefit from laser scoring followed by cleaving to singulate individual substrates from each other.

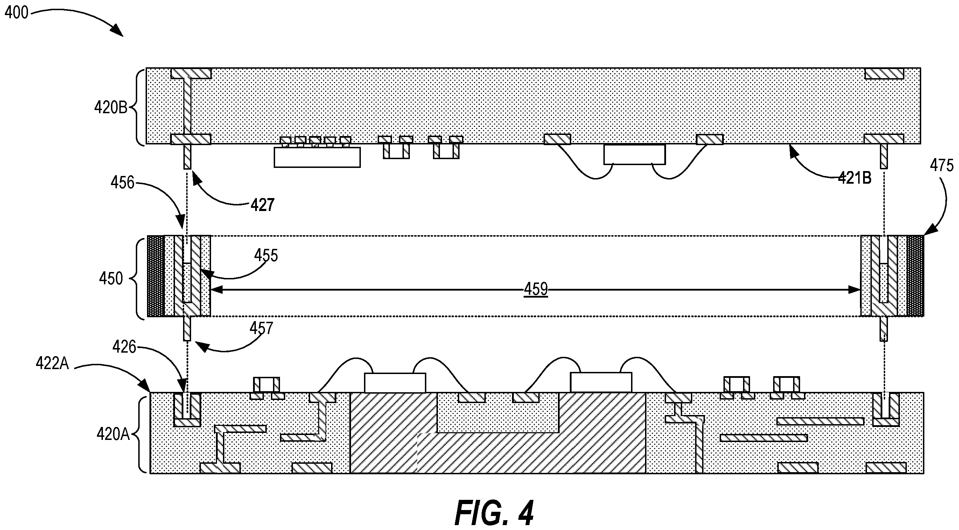

FIG. 4 is a partially exploded cross-section of another example assembly presented to illustrate embodiments in which carriers are joined to each other via interposers via a system of mating pins and sockets. The assembly 400 includes a carrier 420A and a carrier 420B that are joined by an interposer 450 having an aperture 459 passing through it. In this example, the carrier 420A includes a metalized socket 426 at the upper surface 422A that extends into the carrier 420A. The socket 326 configured to receive a corresponding metalized pin. The interposer 450 includes an interconnect 455 (related to the interconnects 155 of the interposers 150) which is provided with a pin 457 on one surface that is configured to mate with a corresponding socket such as the socket 426 of the carrier 420A. The interconnect 455 also includes, on an opposite surface of the interposer 350, a metalized socket 456 configured to mate with a corresponding pin. In this example, the carrier 420B includes pins 427 (optionally coupled to interconnects on and/or within the carrier 420B) on its lower surface 421B which are configured to mate with the socket 456 of the interposer 450. It will be appreciated that in one or more embodiments, a socket such as a socket 426 or a socket 456 is configured as a mechanical connection point only while in one or more other embodiments, such a socket is configured to perform as both a mechanical connection point and an electrical connection point. In some embodiments, a pin and/or socket which does not make an electrical connection may not be metalized.

It will be appreciated that, in embodiments which include an interposer such as the interposer 450 or related interposers, pins and sockets may be arranged in any suitable manner. For instance, an interposer may have only sockets on both surfaces and the corresponding pins may be disposed on the carriers. Alternatively, a carrier (e.g., a carrier 420) and/or an interposer (e.g., the interposer 450) may have both sockets (e.g., a socket 426 or 456) and pins (e.g., pins 427 or 457) on one or both of top and lower surfaces, distributed in any suitable arrangement. It will be understood that assemblies such as the assembly 400 and related assemblies can be fabricated in bulk using panel level processes such as the process 300 or similar processes.

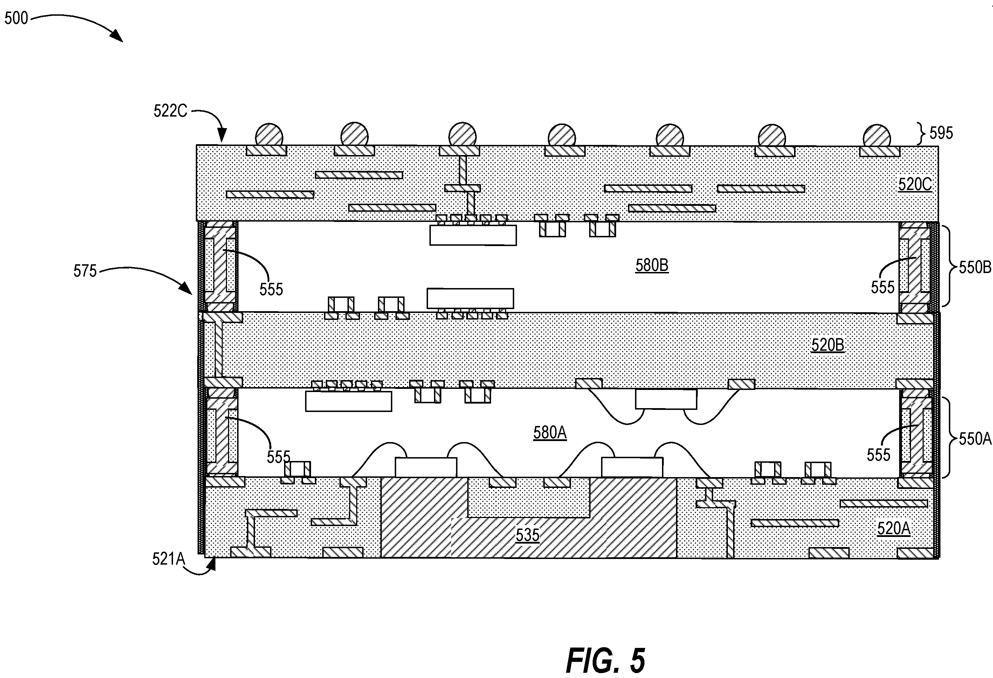

As above, "muti-tier" packages can be fabricated according to embodiments herein. FIG. 5 shows an example two-tier assembly, for purposes of illustration. It will be appreciated that The assembly 500 includes three carriers, 520 (the carrier 520A, 520B, 520C) and two interposers 550 that include interconnects 555 (the interposers 550A, 550B). A cavity 580A is formed between the carriers 520A and 520B and a cavity 580B is formed between the carriers 520B and 520C. In the example of FIG. 5, the assembly 500 includes external interconnects 595 on the top surface 522C of the carrier 520C, represented by solder bumps 595 bonded to metallic contact pads. Such interconnections can allow the assembly 500 (or a similar assembly) to be "flipped" relative to the orientation shown in FIG. 5 and coupled to a larger assembly such as a circuit board, leaving the bottom surface 521A of the carrier 520A exposed (e.g., to allow bonding of a heatsink or other thermal structure to a coin or other thermal structure such as the coin 535 of the assembly 500, or a structure such as the coin 135 of the assembly 100).

The assembly 500 includes molding material 575 (e.g., molding material 175 or 475) that can seal gaps between the interposers 550 (i.e., the interposers 550A and 550B) and the carriers 520 (i.e., the carriers 520A, 520B, and 520C). It will be understood that, in one or more embodiments, molding material such as the molding material 575 can be applied around all substrates in a tiered assembly such as the assembly 500 (i.e., the molding material can also surround the sides of the carrier 520C and/or extend onto all or part of the upper surface 522C of the carrier 520C and/or extended onto all or part of the lower surface 521A of the carrier 520A). Similarly, in one or more embodiments, molding material such as the molding material 575 is selectively applied to or more substrates or interfaces between substrates (e.g., at an interface between an interposer 550 and a carrier 520).

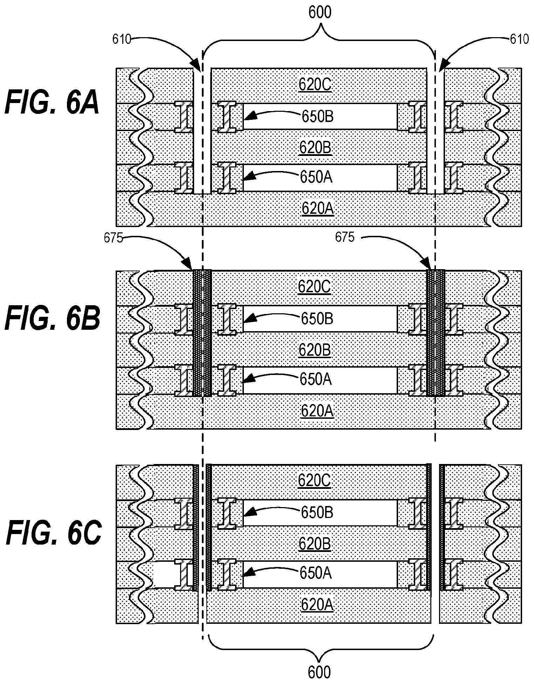

Multi-tiered assemblies such as the assembly 500 and other assemblies with two or more tiers can be fabricated in panel-level processes related to the process 300 of FIG. 3, as described below in connection with FIGs. 6A, 6B, and 6C, which show cross-sectional views illustrating singulation of an assembly 600 from a larger panel assembly. The assembly 600 is formed by the three carriers 620A, 620B, and 620C (e.g., carriers 120, 320, 420, or 520) and the two interposers 650A, 650B (e.g., interposers 150, 450, or 550).

As shown in FIG. 6A, multiple stacked panels can be diced to create channels above corresponding carriers (e.g., the carrier 620A and neighboring carriers), analogously to the dicing step 320 of the process 300. As shown in FIG. 6B, the channels shown in FIG. 6A can be filled by molding material 675 (e.g., molding material 175, 475, or 575) material that surrounds the interposers 650A and 650B (as well as the carriers 620B, 620C), analogously to step 330 of the process 300. Finally, as shown, in FIG. 6C, the assembly 600 can be singulated from neighboring assemblies by dicing through the molding 675 in the channels 610 and the bottommost carrier 620A, analogous to step 340 of the process 300.

It will be understood that interposers according to embodiments herein are described for purposes of illustration as continuous substrates provided with apertures (e.g., apertures 159 or 459) are intended as nonlimiting examples. For instance, in one or more embodiments, an interposer (e.g., an interposer 150, 450, 550, or 650) is formed from individual interposer units (which may be referred to as "bricks" or "blocks") which are individually bonded to carriers (e.g., carriers 120, 420, 520, or 620) which can be bonded together by a molding material or other adhesive material. In one or more embodiments such embodiments, individual units are molded to form a single interposer substrate prior to being bonded to one or more carriers, whereas in one or more such embodiments, individual interposer units are molded together after they are bonded to one or more carriers.

### VARIOUS EXAMPLES

Features of embodiments may be understood by way of one or more of the following examples:
Example 1: a method or device that includes a first substrate panel having an upper surface and lower surface, the first substrate panel including a first circuit substrate; and a second substrate panel having an upper surface and lower surface that includes a first interposer substrate having an aperture that passes through the first interposer substrate. The lower surface of the second substrate panel is bonded the upper surface of the first substrate panel such that the aperture of the first interposer substrate is positioned above the first circuit substrate on the upper surface of the first substrate panel. A first is bonded cover to the upper surface of second substrate panel such that a first cavity is formed between the first circuit substrate and the first cover. Channels are diced in the second substrate panel that pass through the first interposer substrate and expose portions of the upper surface of the first substrate panel that surround the first circuit substrate. A molding material is dispensed in the channels in the second substrate panel such that aperture in the first interposer substrate is surrounded by the molding material.
   A singulated device assembly is produced by dicing through a portion of the molding material in the channels in the second substrate panel and through portions of the first substrate panel underneath the channels. The singulated device assembly includes the first circuit substrate; the first interposer substrate bonded to an upper surface of the first circuit substrate at a lower surface of the first interposer substrate; and the first cover bonded to an upper surface of the first interposer substrate.
Example 2: The device or method of Examples 1, where the portion of the molding material that surrounds the first cavity seals gaps between the first interposer substrate and the first circuit substrate.
Example 3: The device or method of Example 1 or Example 2 where first cover is formed by bonding a lower surface of a third substrate panel to the upper surface of the second substrate panel, the third substrate panel including a second circuit substrate disposed above the aperture in the first interposer substrate; and the singulated device assembly further includes the second circuit substrate bonded to the upper surface of the first interposer substrate.
Example 4: The device or method of any of Examples 1-3 where one or more electrical components are bonded and electrically coupled to a lower surface of the second circuit substrate that is also bonded to the first interposer substrate.
Example 5: The device or method of any of Examples 1-4 where a first electronic component bonded to the second circuit substrate is electrically coupled to first circuit substrate via the first interposer substrate.
Example 6: The device or method of any of Examples 3-5, also includes a fourth substrate panel having an upper surface and a lower surface, the fourth substrate panel including a second interposer substrate with an aperture that passes through the second interposer substrate; and fifth substrate panel having an upper surface and a lower surface, the fifth substrate panel including a third circuit substrate.

The lower surface of the fourth substrate panel is bonded to the upper surface of the third substrate panel such that the aperture in the second interposer substrate is disposed above the second circuit substrate. The lower surface of the fifth substrate panel is bonded to the upper surface of the fourth substrate panel such that a second cavity is formed between the second circuit substrate and the third circuit substrate. Channels are diced that pass through the fifth substrate panel and the fourth substrate panel and separate the third circuit substrate from the fifth substrate panel and the separate the second interposer substrate from the fourth substrate panel.

The molding material is dispensed in the channels in the fourth substrate panel such that aperture in the second interposer substrate is surrounded by the molding material and producing the singulated device assembly further includes dicing through a portion of the molding material in the channels in the fourth substrate panel and in the channels in the fifth substrate panel.

The singulated device assembly further includes the second interposer substrate; the third circuit substrate bonded to the second interposer substrate; and the second cavity disposed between the third circuit substrate and the second interposer substrate.

Example 7: The device or method of Example 1 that also includes a third substrate panel having an upper surface and a lower surface, the third substrate panel including a second interposer substrate with an aperture that passes through the second interposer substrate.

The lower surface of the third substrate panel is bonded to the upper surface of the second substrate panel such that the aperture in the second interposer substrate is disposed above the first cover and a second cover is bonded to the upper surface of the fourth substrate panel such that a second cavity is formed between the second interposer substrate and the second cover. Channels are diced that pass through the third substrate panel that separate the second interposer substrate from the third substrate panel.

The molding material is dispensed in the channels in the third substrate panel such that aperture in the second interposer substrate is surrounded by the molding material and producing the singulated device assembly further includes dicing through a portion of the molding material in the channels in the third substrate panel. The singulated device assembly further includes the second interposer substrate; the second cover bonded to the second interposer substrate; and the second cavity disposed between the second cover and the second interposer substrate.

Example 8: The device or method of Example 7 where the first cover is formed by a second circuit substrate.

Example 9: A device or method in which a panel assembly that includes a first substrate panel that includes a set of first circuit substrates that include electronic components; and a second substrate panel bonded above the first substrate panel that includes a set of first interposer substrates having apertures disposed over corresponding first circuit substrates of the first substrate panel. The panel assembly is partially diced to form channels that pass through the second substrate panel. The panel assembly is singulated into singulated circuit assemblies by dicing through a portion of the molding material in the channels that pass through the second substrate panel and dicing through the first substrate panel beneath the channels.

Each singulated circuit assembly includes a first circuit substrate; a first interposer substrate bonded above the first circuit substrate and including a first aperture disposed above a first portion of the first circuit substrate; a first cover bonded above the first aperture such that a first cavity is formed above the portion of the first circuit substrate; and molding material that at least partially surrounds the first interposer substrate.

Example 10: The device or method of Examples 9 in channels that pass through the second substrate panel are filled with the molding material.

Example 11: The device or method of any of Example 9 or Example 10, where the molding material seals gaps between the first interposer substrate and the first circuit substrate.

Example 12: The device or method of any of Examples 9-11 where the molding material electrically isolates electrical interconnections between the first interposer substrate and the first circuit substrate.

Example 13: The device or method of any of Examples 9-12, where the first cover of each singulated circuit assembly is formed by a second circuit substrate bonded above the first interposer substrate.

Example 14: The device or method of any of Examples 9-13, where the panel assembly also includes a third substrate panel bonded above the second substrate panel that includes a set of second interposer substrates having apertures disposed above corresponding first circuit substrates of the first substrate panel; and a fourth substrate panel that includes a set of second circuit substrates bonded to the third substrate panel above the apertures of the second interposer substrates;

Each singulated circuit assembly also includes a second interposer substrate bonded above the first cover and including a second aperture disposed above the first cover; and a second circuit substrate bonded above the second interposer substrate such that a second cavity is formed above the first cover.

Example 15: The device or method of any of Examples 9-14 where the first cover of each singulated circuit assembly is formed by a third circuit substrate bonded between the first interposer substrate and the second interposer substrate.

Example 16: The device or method of any of Examples 9-15, where the panel assembly further includes a third substrate panel that includes a set of second circuit substrates; and dicing through a portion of the third substrate panel above the channels that pass through the second substrate panel. The cover of each singulated circuit assembly is formed by a corresponding second circuit substrate of the set of second circuit substrates.

Example 17: The device or method of any of Examples 9-16, where the third substrate panel is bonded to the second substrate panel.

Example 18: the device or method of any of Examples 9-17, where the panel assembly also includes a third substrate panel bonded above the second substrate panel that includes a set of second circuit substrates that form the first cover of each singulated circuit assembly; a fourth substrate panel that includes a set of second interposer substrates having apertures disposed above corresponding second circuit substrates of the second substrate panel; and a fifth substrate panel that includes a set of third circuit substrates bonded to the fourth substrate panel above the apertures of the second interposer substrates.

Each singulated circuit assembly also includes a second interposer substrate bonded above the second circuit substrate and including a second aperture disposed above second circuit substrate; and a third circuit substrate bonded above the second interposer substrate such that a second cavity is formed above second circuit substrate.

Example 19: A device or method that includes a panel assembly including a first substrate panel that includes a set of first circuit substrates that include electronic components; and a second substrate panel bonded above the first substrate panel that includes a set of first interposer substrates having apertures disposed over corresponding first circuit substrates of the first substrate panel.

The panel assembly is partially diced to form channels that pass through the second substrate panel. The panel assembly is singulated into singulated circuit assemblies by dicing through a portion of molding material in the channels that pass through the second substrate panel and dicing through the first substrate panel beneath the channels.

Each singulated circuit assembly includes a first circuit substrate that includes a thermally-conductive structure that passes through the first circuit substrate; a first interposer substrate bonded above the first circuit substrate and including a first aperture disposed above a first portion of the first circuit substrate; a first cover bonded above the first aperture such that a first cavity is formed above the portion of the first circuit substrate; and an electronic device disposed on an upper surface of the first circuit substrate and thermally coupled to a lower surface of the first circuit substrate via the thermally-conductive structure.

Example 20: The device or method of Example 19, where each singulated assembly further includes one or more electronic components disposed on or within the first circuit substrate that are electrically coupled to an electrical contact outside the first cavity via an electrical interconnect within the first interposer substrate.

Example 21: The device or method of Example 19 or Example 20 where each singulated assembly also includes a portion of the molding material in the channels that pass through the second substrate panel that remains after dicing through the channels; and the molding material electrically isolates electrically conductive structures of the first interposer substrate.

The preceding detailed description and examples are merely illustrative in nature and are not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no Intention to be bound by any expressed or implied theory presented in the preceding technical field, background, or detailed description.

It should be understood that this invention is not limited in its application to the details of construction and the arrangement of components set forth in the preceding description or illustrated in the accompanying drawings. The invention is capable of other embodiments and of being practiced or of being carried out in various ways. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

**The** preceding discussion is presented to enable a person skilled in the art to make and use embodiments of the invention. Various modifications to the illustrated embodiments will be readily apparent to those skilled in the art, and the generic principles herein can be applied to other embodiments and applications without departing from embodiments of the invention. Thus, embodiments of the invention are not intended to be limited to embodiments shown, but are to be accorded the widest scope consistent with the principles and features disclosed herein. The preceding detailed description is to be read with reference to the figures, in which like elements in different figures have like reference numerals. The Figures, which are not necessarily to scale, depict selected embodiments and are not intended to limit the scope of embodiments of the invention. Skilled artisans will recognize the examples provided herein have many useful alternatives and fall within the scope of embodiments of the invention.

The connecting lines shown in the various figures contained herein are intended to represent exemplary functional relationships and/or physical couplings between the various elements. It should be noted that many alternative or additional functional relationships or physical connections may be present in one or more embodiments of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in one or more embodiments of the depicted subject matter.

## Claims

1. A method comprising:
receiving a first substrate panel having an upper surface and lower surface, the first substrate panel including a first circuit substrate;
receiving a second substrate panel having an upper surface and lower surface that includes a first interposer substrate having an aperture that passes through the first interposer substrate;
bonding the lower surface of the second substrate panel to the upper surface of the first substrate panel such that the aperture of the first interposer substrate is positioned above the first circuit substrate on the upper surface of the first substrate panel;
bonding a first cover to the upper surface of second substrate panel such that a first cavity is formed between the first circuit substrate and the first cover;
dicing channels in the second substrate panel that pass through the first interposer substrate and expose portions of the upper surface of the first substrate panel that surround the first circuit substrate;
dispensing a molding material in the channels in the second substrate panel such that aperture in the first interposer substrate is surrounded by the molding material; and
producing a singulated device assembly by dicing through a portion of the molding material in the channels in the second substrate panel and through portions of the first substrate panel underneath the channels;
wherein the singulated device assembly includes:
the first circuit substrate;
the first interposer substrate bonded to an upper surface of the first circuit substrate at a lower surface of the first interposer substrate; and
the first cover bonded to an upper surface of the first interposer substrate.

2. The method of Claim 1, wherein the portion of the molding material that surrounds the first cavity seals gaps between the first interposer substrate and the first circuit substrate.

3. The method of Claim 1 or 2, further comprising:
forming the first cover by bonding a lower surface of a third substrate panel to the upper surface of the second substrate panel, the third substrate panel including a second circuit substrate disposed above the aperture in the first interposer substrate;
wherein the singulated device assembly further includes the second circuit substrate bonded to the upper surface of the first interposer substrate.

4. The method of Claim 3,
wherein one or more electrical components are bonded and electrically coupled to a lower surface of the second circuit substrate that is also bonded to the first interposer substrate.

5. The method of Claim 3 or 4,
wherein a first electronic component bonded to the second circuit substrate is electrically coupled to first circuit substrate via the first interposer substrate.

6. The method of Claim 3, 4 or 5, further comprising:
receiving a fourth substrate panel having an upper surface and a lower surface, the fourth substrate panel including a second interposer substrate with an aperture that passes through the second interposer substrate;
receiving a fifth substrate panel having an upper surface and a lower surface, the fifth substrate panel including a third circuit substrate;
bonding the lower surface of the fourth substrate panel to the upper surface of the third substrate panel such that the aperture in the second interposer substrate is disposed above the second circuit substrate;
bonding the lower surface of the fifth substrate panel to the upper surface of the fourth substrate panel such that a second cavity is formed between the second circuit substrate and the third circuit substrate;
dicing channels that pass through the fifth substrate panel and the fourth substrate panel that separate the third circuit substrate from the fifth substrate panel and the separate the second interposer substrate from the fourth substrate panel; and
dispensing the molding material in the channels in the fourth substrate panel such that aperture in the second interposer substrate is surrounded by the molding material;
wherein producing the singulated device assembly further includes dicing through a portion of the molding material in the channels in the fourth substrate panel and in the channels in the fifth substrate panel; and
wherein the singulated device assembly further includes:
the second interposer substrate;
the third circuit substrate bonded to the second interposer substrate; and
the second cavity disposed between the third circuit substrate and the second interposer substrate.

7. The method of any preceding Claim, further comprising:
receiving a third substrate panel having an upper surface and a lower surface, the third substrate panel including a second interposer substrate with an aperture that passes through the second interposer substrate;
bonding the lower surface of the third substrate panel to the upper surface of the second substrate panel such that the aperture in the second interposer substrate is disposed above the first cover;
bonding a second cover to the upper surface of the fourth substrate panel such that a second cavity is formed between the second interposer substrate and the second cover;
dicing channels that pass through the third substrate panel that separate the second interposer substrate from the third substrate panel; and
dispensing the molding material in the channels in the third substrate panel such that aperture in the second interposer substrate is surrounded by the molding material;
wherein producing the singulated device assembly further includes dicing through a portion of the molding material in the channels in the third substrate panel; and
wherein the singulated device assembly further includes:
the second interposer substrate;
the second cover bonded to the second interposer substrate; and
the second cavity disposed between the second cover and the second interposer substrate.

8. The method of Claim 7, wherein the first cover is formed by a second circuit substrate.

9. A method comprising:
providing a panel assembly that comprises:
a first substrate panel that includes a set of first circuit substrates that include electronic components; and
a second substrate panel bonded above the first substrate panel that includes a set of first interposer substrates having apertures disposed over corresponding first circuit substrates of the first substrate panel;
partially dicing the panel assembly to form channels that pass through the second substrate panel; and
singulating the panel assembly into singulated circuit assemblies by dicing through a portion of the molding material in the channels that pass through the second substrate panel and dicing through the first substrate panel beneath the channels;
wherein, each singulated circuit assembly comprises:
a first circuit substrate;
a first interposer substrate bonded above the first circuit substrate and including a first aperture disposed above a first portion of the first circuit substrate;
a first cover bonded above the first aperture such that a first cavity is formed above the portion of the first circuit substrate; and
molding material that at least partially surrounds the first interposer substrate.

10. The method of claim 9, further comprising filling the channels that pass through the second substrate panel with the molding material.

11. The method of claim 9 or 10, wherein the molding material seals gaps between the first interposer substrate and the first circuit substrate.

12. The method of any of claims 9 to 11. wherein the molding material electrically isolates electrical interconnections between the first interposer substrate and the first circuit substrate.

13. The method of any of Claims 9 to 12, wherein the first cover of each singulated circuit assembly is formed by a second circuit substrate bonded above the first interposer substrate.

14. The method of any of Claims 9 to 13, wherein the panel assembly further comprises:
a third substrate panel bonded above the second substrate panel that includes a set of second interposer substrates having apertures disposed above corresponding first circuit substrates of the first substrate panel; and
a fourth substrate panel that includes a set of second circuit substrates bonded to the third substrate panel above the apertures of the second interposer substrates; and
wherein each singulated circuit assembly further comprises:
a second interposer substrate bonded above the first cover and including a second aperture disposed above the first cover;
a second circuit substrate bonded above the second interposer substrate such that a second cavity is formed above the first cover.

15. The method of Claim 14, wherein the first cover of each singulated circuit assembly is formed by a third circuit substrate bonded between the first interposer substrate and the second interposer substrate.
